(19) Europäisches Patentamt / European Patent Office / Office européen des brevets

(11) **EP 4 236 079 A1**

(12) **EUROPEAN PATENT APPLICATION**

(43) Date of publication:
**30.08.2023 Bulletin 2023/35**

(21) Application number: **22158856.9**

(22) Date of filing: **25.02.2022**

(51) International Patent Classification (IPC):
**H03L 7/10** $^{(2006.01)}$    **G06N 20/00** $^{(2019.01)}$

(52) Cooperative Patent Classification (CPC):
**H03L 7/104; G06N 20/00**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Siemens Aktiengesellschaft 80333 München (DE)**

(72) Inventors:
• **Hein, Daniel**
  **81549 München (DE)**
• **Limmer, Steffen**
  **80687 München (DE)**
• **Mondal, Gopal**
  **91058 Erlangen (DE)**
• **Nielebock, Sebastian**
  **91301 Forchheim (DE)**
• **Sterzing, Volkmar**
  **85579 Neubiberg (DE)**

(74) Representative: **Siemens Patent Attorneys Postfach 22 16 34 80506 München (DE)**

(54) **COMPUTER-IMPLEMENTED METHOD FOR CALIBRATING A PHASE-LOCKED LOOP BASED SIGNAL CLEAN-UP CIRCUIT AND CALIBRATION SYSTEM**

(57)  In order to calibrate a "phase-locked loop <PLL>"-based signal clean-up circuit (SCUC) automatically, it is proposed on the basis of input values (IPV) being received (rcv) for a calibration process and belonging to a noisy input signal ($IPS_n$) with an amplitude and a frequency dynamically changed and being synchronous with a clean, unitary signal of the signal clean-up circuit to
- train (trn) a machine-learning module (MLM) (i) by samples of generated training data (TDG) regarding a sampling-frequency used for the training "fs_train", a random lock-in-frequency used for the training and around a defined target "f0_train" and random noise and distortions of the received input values (IPV, $IPV_{ph}$, $IPV_{1-ph}$, $IPV_{3-ph}$), and (ii) according to generated machine learning module weights (MLMW),
- preprocess (prpc) the received input values (IPV, $IPV_{ph}$, $IPV_{1-ph}$, $IPV_{3-ph}$) by combining regarding sampling-frequencies "fs" and lock-in-frequencies "f0" multiple adjustable delays and multiple threshold counters with variable increment to enable a reconfiguration of each the sampling-frequency "fs" and each the lock-in-frequency "f0" without retraining the machine learning module weights (MLMW),
- input (ipt) the preprocessed input values into the trained machine-learning module (MLM),
- provide (pvd) by the trained machine-learning module (MLM) estimated, weighted output values (OPV) related accordingly to the received input values (IPV, $IPV_{ph}$,

$IPV_{1-ph}$, $IPV_{3-ph}$).

**Description**

The invention refers to a computer-implemented method for calibrating a "phase-locked loop <PLL>" based signal clean-up circuit according to the preamble claim 1 and a calibration system according to the preamble claim 13.

According to https://powersimtech.com/resources/tutorials/implementation- and-design-of-pll-and-enhanced-pll-blocks/ "phase-locked loop (PLL)"-technology (e.g., PLL-circuits) have been widely used in many engineering applications. The primary function of the PLL-principle behind the technology is to generate a clean, unitary signal which is synchronous with a noisy input signal where the amplitude and frequency can change with time. This is required in almost all technical systems that are interfaced with an AC power grid and are intended to interact with it in an active and controlled manner. This includes grid-connected inverters, rectifier loads, motor drives, and battery chargers.

The PLL-technology has also been extended to perform secondary tasks such as estimation of signal attributes including the magnitude, frequency, harmonics, sequence components, etc.

Another important task of the PLL-technology in power electronics and power system-based technology is to estimate the grid impedance to control the stability of the system.

From the cited reference it is known a conventional single-phase PLL (1-phase PLL) has a very simple yet robust structure. The block diagram of the conventional PLL based on a proportional integral controller, called as PI-controller, with the definitions of signals, is shown in Picture 1. Due to the presence of large double-frequency ripples, the single-phase PLL is not suitable for applications that require high level of accuracy.

The Picture 1 shows a conventional single-phase PLL with the following PLL-parameter:

   u(t) = input signal to the PLL
   ωo = rated frequency of the input
   y(t) = unitary output signal synchronous with the input
   y'(t) = unitary output signal 90-degree delayed version of y(t)
   Φ = estimated angle
   ω = estimated frequency in rad/sec.
   kp = proportional gain
   ki = integrating gain

It is further known from the cited reference a conventional triple-phase PLL (3-phase PLL), which does not have the problem of the double-frequency ripple due to the fact that the ripples of the three phases cancel each other. However, when the 3-phase inputs are not balanced, the double-frequency ripple will be present.

The block diagram of the conventional 3-phase PLL, with the definitions of signals, is shown in Picture 2.

The Picture 2 shows a conventional triple-phase PLL with the following PLL-parameter:

   u(t) = input signal to the PLL
   ωo = rated frequency of the input
   y(t) = unitary output signal synchronous with the input
   y'(t) = unitary output signal 90-degree delayed version of y(t)
   Φ = estimated angle
   ω = estimated frequency in rad/sec.
   ud = d-axis component of the input
   uq = q-axis component of the input
   uo = zero-axis component of the input
   kp = proportional gain
   ki = integrating gain

The "abc/dqo"-transformation is defined as:

$$\begin{bmatrix} u_d \\ u_q \\ u_o \end{bmatrix} = \frac{2}{3} \begin{bmatrix} \cos(\phi) & \cos(\phi - \frac{2\pi}{3}) & \cos(\phi + \frac{2\pi}{3}) \\ \sin(\phi) & \sin(\phi - \frac{2\pi}{3}) & \sin(\phi + \frac{2\pi}{3}) \\ \frac{1}{2} & \frac{1}{2} & \frac{1}{2} \end{bmatrix} \begin{bmatrix} u_a \\ u_b \\ u_c \end{bmatrix}$$

Moreover, from the WO 2007/147649 A2 it is known a current source inverter and a method for uninterrupted switching of the current source inverter, which comprises means for operating the inverter in fundamental frequency unregulated operation, means

for operating the inverter in clocked voltage regulated operation, means for recording parameters from which conclusions can be drawn at an instantaneous operating point and/or at an instantaneous network condition, means for determining an appropriate operating condition from the recorded parameters and means for uninterrupted switching of the operation of the inverter to the operating condition as determined from the recorded parameters.

Furthermore, from the DE 10 2012 209227 A1 it is known a method, an apparatus, and a system of measuring frequency, wherein

- a first number of full cycles of a signal at a rate based on a nominal frequency of the signal are sampled,
- the samples to digital samples are converted,
- the digital samples to identify a first pair of digital samples with each one disposed on either side of a first zero-crossing and a second pair of digital samples with each one disposed on either side of a last full cycle zero-crossing are processed,

- the first pair of digital samples and the second pair of digital samples to determine a position of the first and last zero-crossings relative to each other in time; and calculating a fundamental frequency of the signal based on the first number of full cycles sampled and the relative position of the first and last zero-crossings are interpolated.

It is an objective of the invention to propose a method for calibrating a "phase-locked loop <PLL>" based signal clean-up circuit and a calibration system, by which the calibration is done automatically

(i) to avoid the necessity of technical experts because of no well-established rules exist between sampling/lock-on frequency and PLL-parameters for calibrating the PLL-parameter
(ii) to bypass trial-and-error approaches by connecting the PLL-circuit to a technical system before moving on with a control of the technical system, e.g., an AC power grid with electric power converter before moving on with the control of the converter
(iii) although conventional PLL-circuits may show slow convergence and/or instability for unfavorable noise distributions, distorted input signals or fault scenarios
(iv) even though conventional PLL-circuits cannot automatically optimize themself for different sample frequencies or lock-in frequencies during runtime.

This objective is solved regarding to a method defined in the preamble of claim 1 by the features in the characterizing part of claim 1.

Furthermore, the objective is solved regarding to a calibration system defined in the preamble of claim 13 by the features in the characterizing part of claim 13.

The main idea of the invention according to the claim 1 - in order to calibrate a "phase-locked loop <PLL>"-based signal clean-up circuit on the basis of input values, in particular related to at least one phase, e.g., a "1-phase" related input values or "3-phase" related input values, being received for a calibration process and belonging to a noisy input signal with an amplitude and a frequency dynamically changed and being synchronous with a clean, unitary signal of the signal clean-up circuit - consists in

- training a machine-learning module (i) by samples of generated training data regarding (i1) a sampling-frequency used for the training "fs_train", (i2) a random lock-in-frequency used for the training and around a defined target, in particular an average target, "f0_train" and (i3) random noise and distortions of the received input values, and (ii) according to generated machine learning module weights,
- preprocessing the received input values regarding sampling-frequencies "fs", being each equal or unequal to the training-used sampling-frequency "fs_train", and lock-in-frequencies "f0", being each equal or unequal to the training-used lock-in frequency "f0_train", by combining multiple adjustable delays and multiple threshold counters with variable increment to enable a reconfiguration of each the sampling-frequency "fs" and each the lock-in-frequency "f0" without retraining the machine learning module weights,
- inputting the preprocessed input values into the trained machine-learning module,
- providing by the trained machine-learning module estimated, weighted output values related accordingly to the received input values.

The presented approach enables that (1) a PLL-parameter calibration can be done by non-experts as the sampling frequency, the lock-on frequency and PLL-parameters can be set directly. Thus, a simplified rapid prototyping and simulations can be achieved for different control architectures, e.g., 50Hz/60Hz AC power grids, (**2**) the "machine-learning module"-based training for the PLL-calibration ensures optimal tuning to a wide range of noise distributions, distortions, and fault scenarios as well as fast lock-in time, (**3**) the "machine-learning module"-based training for the PLL-calibration can automatically self-optimize its performance during runtime for wide range of sample frequencies and lock-in frequencies by automatic dynamic reconfiguration, and (**4**) it is solved the issue that "machine-learning module"-based solutions generally required continuous output which is not the case for the "phase-locked loop <PLL>"-based signal clean-up circuit.

The described approach is designed according to claim 13 for a calibration system, which can be preferably used as a computer-implemented-tool embodied for instance as a Computer-Program-Product being designed as an "APP".

The calibration system, which is based on (**i**) a non-transitory, processor-readable storage medium having processor-readable program-instructions of a program module stored in the non-transitory processor-readable storage medium and (**ii**) a processor connected with the storage medium executing the processor-readable program-instructions of the program module, is designed such that (**1**) the program module includes either a training data generator, a machine-learning module and a preprocessing entity or a training data generator, a machine-learning module, a preprocessing entity and a postprocessing entity, and (**2**) the processor executes the processor-readable program-instructions of the program module and thereby accesses to the included components to execute the described approach.

Further advantageous developments of the invention are specified and given in the dependent claims.

So according to the claim 2 it would be an advantage of the invention that the multiple counters are initialized for a defined threshold on y-coordinate axis, a defined input phase on x-coordinate axis and a type of y-coordinate level crossing, e.g., positive and/or negative, wherein for each counter a logic is applied such that:

> **a**) in each cycle the counter is incremented by base increment values "incv_base"
> **b**) the counter is reset each time the received input values crosses its defined threshold and count direction.

An example is provided in Picture 3 for positive direction crossing and thresholds at 0 (red lines in the Picture 3), 0.5 (orange lines in the Picture 3), 0.9 (light orange lines in the Picture 3)

The Picture 3 shows an illustration of the multiple counters with vector of thresholds =[-0.5, 0., 0.5, 0.97 ...] and the base increment values "incv_base".

Furthermore, it would be advantageous according to the claim 3 that an delay length "DL" using integer multiples of an base delay "D_base=x samples" is instantiated depending on the sampling-frequencies "fs" being required and a counter increment of the counters, which based on the training-used sampling-frequency "fs_train" and the training-used lock-in-frequency "f0_train" is initialized to a primary-base increment value "incv_base_p~f0_train/fs_train" of the base increment values "incv_base".

In addition, according to the claim 4, the invention is developed advantageously by reconfiguring the lock-in-frequency from the lock-in-frequency "f0" to a new lock-in-frequency "f0_new" according to which

> - a base delay adjustment changed from the base delay

> > "D_base=x samples" to a primary base delay
> > "D_base_p~x*(f0_train/f0_new) samples" and

> - a counter increment change from the primary-base increment value "incv_base_p~f0_train/fs_train" to a secondary-base increment value "incv_base_s~f0_new/fs_train" of the base increment values "incv_base"

are carried out.

As an alternative option in advantageously developing the invention according to the claim 5 the sampling-frequency "fs" reconfiguration from the training-used sampling-frequency "fs_train", e.g., "fs_train=8kHz", to a new sampling frequency "fs_new", e.g., "fs_new=12kHz", comprises

> - a further base delay adjustment changed from the base delay

> > "D_base=x samples" to a secondary base delay
> > "D_base_s~x*(fs_new/fs_train) samples", e.g., the base delay
> > "D_base=6*(12kHz/8kHz)=9 samples", and if needed or necessary, a result of the calculated second fraction is rounded to an integer next to the result,

> - a counter increment change from the primary-base increment value "incv_base_p~f0_train/fs_train" to a tertiary-base increment value "incv_base_t~f0_new/fs_new" of the base increment values "incv_base".

As a further alternative option in advantageously developing the invention according to the claim 6 the sampling-frequency "fs" reconfiguration from the training-used sampling-frequency "fs_train", to a new sampling frequency "fs_new" comprises

- a further base delay adjustment changed from the primary base delay "D_base_p~x*(f0_train/f0_new) samples" to a tertiary base delay
"D_base_t~x*(f0_train/f0_new)*(fs_new/fs_train) samples", and if needed or necessary a result of the calculated second fraction is rounded to an integer next to the result,
- a counter increment change from the secondary-base increment value "incv_base_s~f0_new/fs_train" to a tertiary-base increment value "incv_base_t~f0-new/fs_new" of the base increment values "incv_base" .

Moreover, according to the claims 7 to 9 it is particularly advantageous that (i) the noisy input signal inputted into the signal clean-up circuit and (ii) the signal clean-up circuit belong to a technical system that is interfaced with an AC power grid and is intended to interact with it in an active and controlled manner.
Following this beneficial approach, where the technical system including the signal clean-up circuit and interfacing with the AC power grid to interact with it in the active and controlled manner, it is favorably chosen according to the claim 8

(1) to use the training-used sampling-frequency "fs_train" as "8kHz",
(2) to use the sample number "x" of the base delays and the new base delays as "x=6" to support by the training-used lock-in frequency "f0_train" a 50Hz-frequency of the AC power grid and to use by the new lock-in frequency "f0_new" a 60Hz-frequency of the AC power grid and
(3) to use the delay length "DL" with the sample number "x=6" as "[1,2,4,8,16]*[D_base=6]=[6,12,24,48,96]".

An exemplary simulation-based connection diagram with respect to a possible preprocessing entity and a machine-learning module concerning the scenario presented above by (1) to (3) is shown in Picture 4. According to this depicted scenario and in addition, a sample with a single delay is fed into the module to realize the counter logic according to the claim 2 (cf. explanations above i.c.w. the Picture 3).
The Picture 4 shows an exemplary simulation-based connection diagram providing inputs and outputs for initialization at "f0_train"= 50Hz, "fs_train"= 8kHz.
Further following this beneficial approach regarding the lock-in-frequency reconfiguration from the lock-in frequency "f0=50Hz" to the new lock-in-frequency "f0_new=60Hz" according to the claim 9 it is proposed

(a) the base delay adjustment from the base delay "D_base=6 samples" to the first new base delay "D_base=6*(50Hz/60Hz)=5 samples", which adapts a new delay length "DL" with the new sample number "x=5" as "[1,2,4,8,16, ...] *[D_base=5]=[5, 10, 20, 40, 80, ...]" and
(b) the counter increment change from the increment value "inc_f=f0_train/fs_train=50/8000" to a new increment value "inc_f = f0_new/fs_train=60/8000".

An exemplary simulation-based connection diagram with respect to a possible preprocessing entity and a machine-learning module concerning the scenario presented above by (a) to (b) is shown in Picture 5. Also, according to this depicted scenario and in addition, a sample with a single delay is fed into the module to realize the counter logic according to the claim 2 (cf. explanations above i.c.w. the Picture 2).
The Picture 5 shows an exemplary simulation-based connection diagram providing inputs and outputs for initialization at "f0_train"= 60Hz, "fs_train"= 8kHz.
Beyond the aforementioned advantageous developments of the invention, it is beneficial

- according to the claim 10 that the signal clean-up circuit is a triple phase PLL-circuit where the estimated, weighted output values are postprocessed combined via median filtering for improved robustness, and/or
- according to the claim 12 that the machine-learning module is an artificial neural network, a Bayesian neural network, a recurrent neural network, a convolutional neural network, multilayer perceptron, autoencoder, support-vector-machine, a data-driven trainable regression model, a k-nearest neighbor regressor, a physical model, a deep neural network regressor and/or a decision tree regressor.

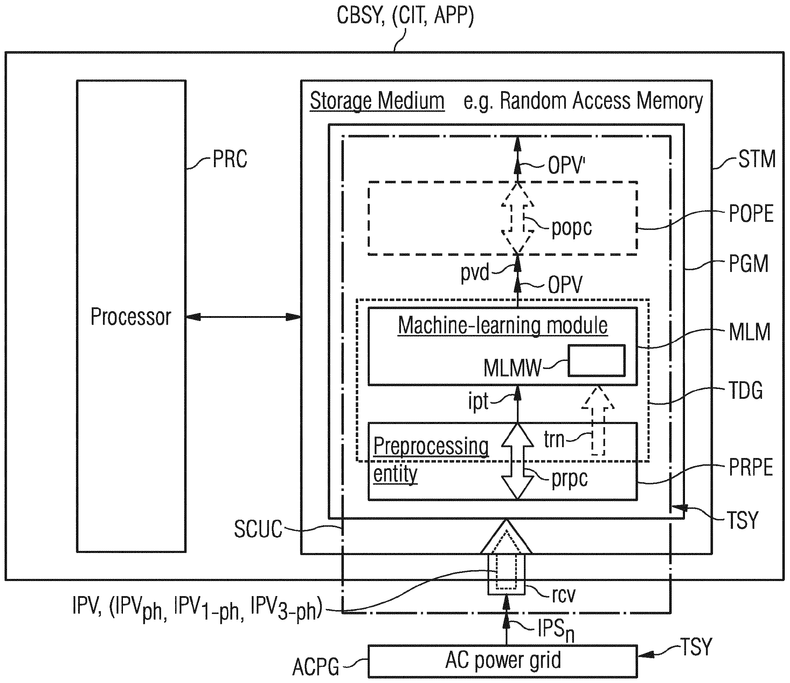

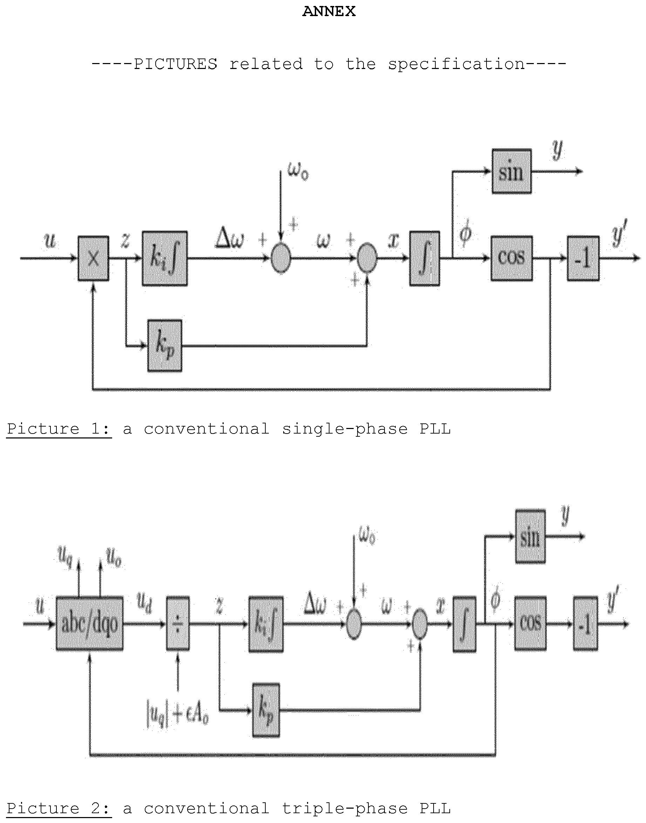

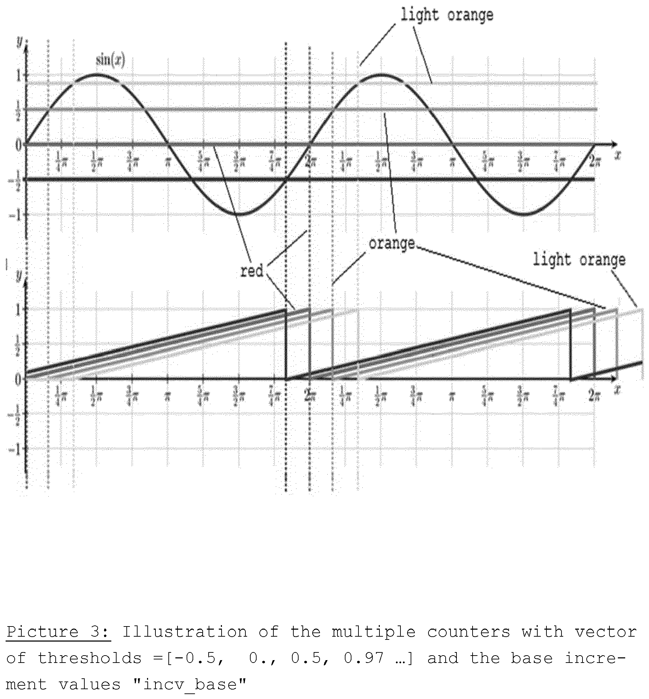

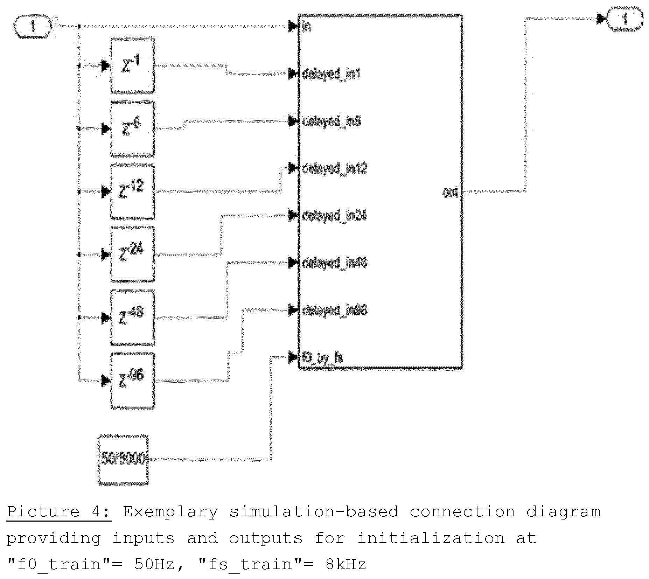

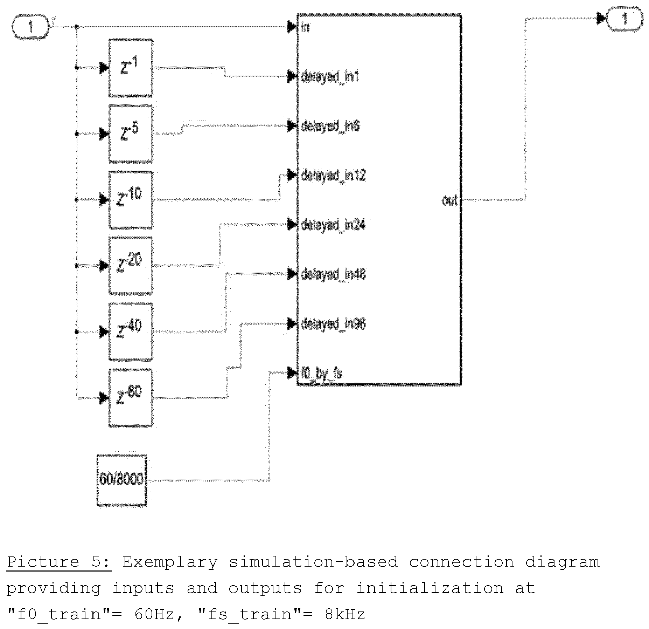

Last but not least it is advantageous according to the claim 11 that the reconfiguration is done dynamically by inversely setting the base delay adjustment and the counter increment change proportional to the estimated, weighted output values. Besides the above, advantageous further developments of the invention arise out of the following description of a preferred embodiment of the invention according to a single FIGURE.

The FIGURE shows the principal design or structure of a calibration system CBSY for calibrating a "phase-locked loop <PLL>"-based signal clean-up circuit SCUC, which belong to a technical system TSY that is interfaced preferably with an AC power grid ACPG and is intended to interact with it in an active and controlled manner. This includes for example grid-connected inverters, rectifier loads, motor drives, and battery chargers. In this context the AC power grid ACPG provides a noisy input signal $IPS_n$ inputted into the signal clean-up circuit SCUC. The noisy input signal $IPS_n$ includes an amplitude and a frequency dynamically changed and being synchronous with a clean, unitary signal of the signal clean-up circuit SCUC.

For the cited purpose the calibration system CBSY carries out a calibration process to calibrate the "phase-locked loop <PLL>"-based signal clean-up circuit SCUC, wherein the calibration process includes a training process TDG, MLM, trn, a preprocessing process PRPE, prpc, and an estimating process MLM, ipt, pvd.

The calibration system CBSY is preferably designed as a computer-implemented-tool CIT, which for example is embodied as a Computer-Program-Product being designed as an "APP" APP, and includes a non-transitory, processor-readable storage medium STM, e.g., a Random Acces Memory <RAM>, having processor-readable program-instructions of a program module PGM stored in the non-transitory processor-readable storage medium STM and a processor PRC connected with the storage medium STM executing the processor-readable program-instructions of the program module PGM.

In the purposeful context the program module PGM includes essentially a training data generator TDG, a machine-learning module MLM and a preprocessing entity PRPE. In addition, it is optionally possible that the program module PGM includes a postprocessing entity POPE, which accordingly is depicted in dashed lines.

In the same context for carrying out a calibration process to calibrate the "phase-locked loop <PLL>"-based signal clean-up circuit SCUC the processor PRC executes the processor-readable program-instructions of the program module PGM and thereby accessing to the training data generator TDG, the machine-learning module MLM and the preprocessing entity PRPE and if necessary, the postprocessing entity POPE.

The calibration process includes a training process TDG, MLM, trn, a preprocessing process PRPE, prpc, and an estimating process MLM, ipt, pvd supplemented optionally by a postprocessing process POPE, popc.

Generally, the starting point for a calibration process is the presence of data. So, in the present case the "phase-locked loop <PLL>"-based signal clean-up circuit SCUC receive rcv input values IPV of the noisy input signal $IPS_n$. These input values are preferably in the case of the AC power grid ACPG input values related to at least one phase $IPV_{ph}$, e.g., a "1-phase" related input value $IPV_{1-ph}$ (*cf. Picture 1 i.c.w. the corresponding explanations*) or "3-phase" related input values $IPV_{3-ph}$ (*cf. Picture 2 i.c.w. the corresponding explanations*).

To carry out the calibration process it is first required that according to the training process TDG, MLM, trn, when the processor PRC accesses to the training data generator TDG, the machine-learning module MLM and the preprocessing entity PRPE of the program module PGM, the machine-learning module MLM is trained trn by samples of training data generated by the training data generator TDG.

Training is generally understood to mean an optimization of a mapping from input data to output data of the machine-learning module MLM. This mapping is optimized according to predetermined criteria during a training phase. A prediction error in the case of prediction models, a classification error in the case of classification models, or a performance of a technical system controlled by the output data in the case of models of reinforcement learning can be used as criteria. The training can be used in particular to set or optimize network structures of neurons in a neural network, weights of connections between the neurons and/or other parameters of the mapping in such a way that the specified criteria are met as well as possible. The training can thus be regarded as an optimization problem. A large number of efficient optimization methods are available for such optimization problems of machine learning. In particular, gradient descent methods, back-propagation methods, particle swarm optimization and/or genetic optimization methods can be used.

Against this technical background the machine-learning module MLM is preferably an artificial neural network, a Bayesian neural network, a recurrent neural network, a convolutional neural network, multilayer perceptron, autoencoder, support-vector-machine, a data-driven trainable regression model, a k-nearest neighbor regressor, a physical model, a deep neural network regressor and/or a decision tree regressor.

In the present case the machine-learning module MLM is trained trn by the samples of the training data generated in the training data generator TDG, when the processor PRC

- regarding a sampling-frequency used for the training "fs_train", a random lock-in-frequency used for the training and around a defined target "f0_train", which could be for example an average target, and random noise and distortions of the received input values IPV, $IPV_{ph}$, $IPV_{1-ph}$, $IPV_{3-ph}$, and
- according to generated machine learning module weights MLMW.

The training process TDG, MLM, trn can be advantageously carried out offline from the actual calibration process.

In the reprocessing process PRPE, prpc, when the processor PRC accesses to the preprocessing entity PRPE of the program module PGM, the received input values IPV, $IPV_{ph}$, $IPV_{1-ph}$, $IPV_{3-ph}$ regarding sampling-frequencies "fs" and lock-in-frequencies "f0" are preprocessed prpc by the preprocessing entity PRPE by combining multiple adjustable delays and multiple threshold counters with variable increment to enable a reconfiguration of each the sampling-frequency "fs" and each the lock-in-frequency "f0" without retraining the machine learning module weights MLMW.

The sampling-frequencies "fs are each equal or unequal to the training-used sampling-frequency "fs_train" and the lock-in-frequencies "f0" are each equal or unequal to the training-used lock-in frequency "f0_train".

In the estimating process MLM, ipt, pvd, when the processor PRC accesses to the preprocessing entity PRPE and the machine-learning module MLM of the program module PGM, the preprocessed input values are inputted ipt into the trained machine-learning module MLM and the trained machine-learning module MLM provides pvd estimated, weighted output values OPV related accordingly to the received input values IPV, $IPV_{ph}$, $IPV_{1-ph}$, $IPV_{3-ph}$.

Furthermore, the reprocessing process PRPE, prpc, when the processor PRC accesses to the preprocessing entity PRPE of the program module PGM, is further designed in such a way that

1) the multiple counters are initialized for a defined threshold on y-coordinate axis, a defined input phase on x-coordinate axis and a type of y-coordinate level crossing, e.g., positive and/or negative, wherein for each counter a logic is applied such that

- in each cycle the counter is incremented by base increment values "incv_base",
- the counter is reset each time the received input values IPV, $IPV_{ph}$, $IPV_{1-ph}$, $IPV_{3-ph}$ crosses its defined threshold and count direction.

2) a delay length "DL" using integer multiples of an base delay "D_base=x samples" is instantiated depending on the sampling-frequencies "fs" being required and a counter increment of the counters, which based on the training-used sampling-frequency "fs_train" and the training-used lock-in-frequency "f0_train" is initialized to a primary-base increment value "incv_base_p~f0_train/fs_train" of the base increment values "incv_base".

3) the lock-in-frequency reconfiguration from the lock-in-frequency "f0" to a new lock-in-frequency "f0_new" comprises

- a base delay adjustment changed from the base delay "D_base=x samples" to a primary base delay "D_base_p~x*(f0_train/f0_new) samples", and
- a counter increment change from the primary-base increment value "incv_base_p~f0_train/fs_train" to a secondary-base increment value "incv_base_s~f0_new/fs_train" of the base increment values "incv_base".

4) the sampling-frequency "fs" reconfiguration from the training-used sampling-frequency "fs_train", e.g., "fs_train=8kHz", to a new sampling frequency "fs_new", e.g., "fs_new=12kHz", comprises

- a further base delay adjustment changed from the base delay

    "D_base=x samples" to a secondary base delay
    "D_base_s~x*(fs_new/fs_train) samples", e.g., the base delay
    "D_base=6*(12kHz/8kHz)=9 samples", and if needed or necessary a result of the calculated second fraction is rounded to an integer next to the result,

- a counter increment change from the primary-base increment value "incv_base_p~f0_train/fs_train" to a tertiary-base increment value "incv_base_t~f0_new/fs_new" of the base increment values "incv_base".

5) the sampling-frequency "fs" reconfiguration from the training-used sampling-frequency "fs_train", to a new sampling frequency "fs_new" comprises

- a further base delay adjustment changed from the primary base delay "D_base_p~x*(f0_train/f0_new) samples" to a tertiary base delay
    "D_base_t~x*(f0_train/f0_new)*(fs_new/fs_train) samples", and if needed or necessary a result of the calculated second fraction is rounded to an integer next to the result,
- a counter increment change from the secondary-base increment value "incv_base_s~f0_new/fs_train" to a tertiary-base increment value "incv_base_t~f0_new/fs_new" of the base increment values "incv_base" .

6) the reconfiguration is done dynamically by inversely setting the base delay adjustment and the counter increment change proportional to the estimated, weighted output values OPV, OPV'.

Beyond that what is described above, when - now according to a particular embodiment of the invention - the signal clean-up circuit SCUC belong to the technical system TSY that is interfaced with the AC power grid ACPG and for the calibration process "1-phase" related input values $IPV_{1-ph}$ or "3-phase"related input values $IPV_{3-ph}$, of the noisy input signal $IPS_n$ are received rcv, the reprocessing process PRPE, prpc, when the processor PRC accesses to the preprocessing entity PRPE of the program module PGM, is further designed in such a way that

1) it is favorably chosen

- the training-used sampling-frequency "fs_train" as "8kHz",
- the sample number "x" of the base delays and the new base delays as "x=6" to support by the training-used lock-in frequency "f0_train" a 50Hz-frequency of the AC power grid and by the new lock-in frequency "f0_new" a 60Hz-frequency of the AC power grid (ACPG) and
- the delay length "DL" with the sample number "x=6" as "[1,2,4,8,16]*[D_base=6]=[6,12,24,48,96]".

2) regarding the lock-in-frequency reconfiguration from the lock-in frequency "f0=50Hz" to the new lock-in-frequency "f0_new=60Hz" it is comprised

- the base delay adjustment changed from the base delay

   "D_base=6 samples" to the first new base delay
   "D_base=6*(50Hz/60Hz)=5 samples", which adapts a new delay length "DL" with the new sample number "x=5" as "[1,2,4,8,16, ...] *[D_base=5]=[5, 10, 20, 40, 80, ...]" and

- the counter increment change from the increment value "inc_f=f0_train/fs_train=50/8000" to a new increment value "inc_f = f0_new/fs_train=60/8000".

3) when the signal clean-up circuit SCUC is a triple phase PLL-circuit with the received "3-phase"related input values $IPV_{3-ph}$ and the estimated, weighted output values OPV are provided pvd by the trained machine-learning module MLM, the estimated, weighted output values OPV are postprocessed popc in the postprocessing entity POPE by corresponding accesses of the processor PRC according to the postprocessing process POPE, popc supplementing the calibration process optionally. This postprocessing process POPE, popc is characterized by combining the estimated, weighted output values OPV via median filtering for improved robustness and generating modified output values OPV'.

**Claims**

1.  Computer-implemented method for calibrating a "phase-locked loop <PLL>"-based signal clean-up circuit (SCUC) including:

    a) receiving (rcv) for a calibration process input values (IPV), in particular related to at least one phase ($IPV_{ph}$), e.g., a "1-phase" related input values ($IPV_{1-ph}$) or "3-phase"related input values ($IPV_{3-ph}$), of a noisy input signal ($IPS_n$) with an amplitude and a frequency dynamically changed and being synchronous with a clean, unitary signal of the signal clean-up circuit (SCUC),

    **characterized by**:

    b) training (trn) a machine-learning module (MLM)
    b1) by samples of generated training data (TDG) regarding

       - a sampling-frequency used for the training "fs_train",
       - a random lock-in-frequency used for the training and around a defined target, in particular an average target, "f0_train"
       - random noise and distortions of the received input values (IPV, $IPV_{ph}$, $IPV_{1-ph}$, $IPV_{3-ph}$), and

**b2**) according to generated machine learning module weights (MLMW),

**c**) preprocessing (prpc) the received input values (IPV, $IPV_{ph}$, $IPV_{1-ph}$, $IPV_{3-ph}$) regarding sampling-frequencies "fs", being each equal or unequal to the training-used sampling-frequency "fs_train", and lock-in-frequencies "f0", being each equal or unequal to the training-used lock-in frequency "f0_train", by combining multiple adjustable delays and multiple threshold counters with variable increment to enable a reconfiguration of each the sampling-frequency "fs" and each the lock-in-frequency "f0" without retraining the machine learning module weights (MLMW),

**d**) inputting (ipt) the preprocessed input values into the trained machine-learning module (MLM),

**e**) providing (pvd) by the trained machine-learning module (MLM) estimated, weighted output values (OPV) related accordingly to the received input values (IPV, $IPV_{ph}$, $IPV_{1-ph}$, $IPV_{3-ph}$).

2. Computer-implemented method according to claim 1, **characterized in that** the multiple counters are initialized for a defined threshold on y-coordinate axis, a defined input phase on x-coordinate axis and a type of y-coordinate level crossing, e.g., positive and/or negative, wherein for each counter a logic is applied such that:

**a**) in each cycle the counter is incremented by base increment values "incv_base"

**b**) the counter is reset each time the received input values (IPV, $IPV_{ph}$, $IPV_{1-ph}$, $IPV_{3-ph}$) crosses its defined threshold and count direction.

3. Computer-implemented method according to claim 1 or 2, **characterized in that** a delay length "DL" using integer multiples of an base delay "D_base=x samples" is instantiated depending on the sampling-frequencies "fs" being required and a counter increment of the counters, which based on the training-used sampling-frequency "fs_train" and the training-used lock-in-frequency "f0_train" is initialized to a primary-base increment value "incv_base_p~f0_train/fs_train" of the base increment values "incv_base".

4. Computer-implemented method according to claim 3, **characterized in that** the lock-in-frequency reconfiguration from the lock-in-frequency "f0" to a new lock-in-frequency "f0_new" comprises

**a**) a base delay adjustment changed from the base delay

"D_base=x samples" to a primary base delay
"D_base_p~x*(f0_train/f0_new) samples" and

b) a counter increment change from the primary-base increment value "incv_base_p~f0_train/fs_train" to a secondary-base increment value "incv _base _s~f0_new/fs _train" of the base increment values "incv_base".

5. Computer-implemented method according to claim 3, **characterized in that** the sampling-frequency "fs" reconfiguration from the training-used sampling-frequency "fs_train", e.g., "fs_train=8kHz", to a new sampling frequency "fs_new", e.g., "fs_new=12kHz", comprises

**a**) a further base delay adjustment changed from the base delay "D_base=x samples" to a secondary base delay "D_base_s~x*(fs_new/fs_train) samples", in particular and if needed or necessay by rounding a result of the calculated second fraction to an integer next to the result, e.g., the base delay "D_base=6*(12kHz/8kHz)=9 samples",
b) a counter increment change from the primary-base increment value "incv_base_p~f0_train/fs_train" to a tertiary-base increment value "incv_base_t~f0_new/fs_new" of the base increment values "incv_base".

6. Computer-implemented method according to claim 4, **characterized in that** the sampling-frequency "fs" reconfiguration from the training-used sampling-frequency "fs_train", to a new sampling frequency "fs_new" comprises

**a**) a further base delay adjustment changed from the primary base delay "D_base_p~x*(f0_train/f0_new) samples" to a tertiary base delay
"D_base_t~x*(f0_train/f0_new)*(fs_new/fs_train) samples", in particular and if needed or necessary by rounding a result of the calculated second fraction to an integer next to the result,
**b**) a counter increment change from the secondary-base increment value "incv_base_s~f0_new/fs_train" to a tertiary-base increment value "incv_base_t~f0_new/fs_new" of the base increment values "incv_base" .

7. Computer-implemented method according to one of the claims 1 to 6, **characterized in that** the noisy input signal ($IPS_n$) inputted into the signal clean-up circuit (SCUC) and the signal clean-up circuit (SCUC) belong to a technical system (TSY) that is interfaced with an AC power grid (ACPG) and is intended to interact with it in an active and controlled manner.

8. Computer-implemented method according to claims 7, **characterized in that** it is favorably chosen (i) the training-used sampling-frequency "fs_train" as "8kHz", (ii) the sample number "x" of the base delays and the new base delays as "x=6" to support by the training-used lock-in frequency "f0_train" a 50Hz-frequency of the AC power grid and by the new lock-in frequency "f0_new" a 60Hz-frequency of the AC power grid (ACPG) and (**iii**) the delay length "DL" with the sample number "x=6" as "[1,2,4,8,16]*[D_base=6]=[6,12,24,48,96]".

9. Computer-implemented method according to claims 4, 5 and 8 or claims 4, 6 and 8, **characterized in that** regarding the lock-in-frequency reconfiguration from the lock-in frequency "f0=50Hz" to the new lock-in-frequency "f0_new=60Hz" it is comprised

    **a**) the base delay adjustment changed from the base delay

      "D_base=6 samples" to the first new base delay
      "D_base=6*(50Hz/60Hz)=5 samples", which adapts a new delay length "DL" with the new sample number "x=5" as "[1,2,4,8,16, ...] *[D_base=5]=[5, 10, 20, 40, 80, ...]" and

    **b**) the counter increment change from the increment value "inc_f=f0_train/fs_train=50/8000" to a new increment value "inc_f = f0_new/fs_train=60/8000".

10. Computer-implemented method according to one of the claims 7 to 9, **characterized in that** the signal clean-up circuit (SCUC) is a triple phase PLL-circuit where the estimated, weighted output values (OPV) are postprocessed (popc) combined via median filtering for improved robustness (OPV').

11. Computer-implemented method according to one of the claims 1 to 10, **characterized in that** the reconfiguration is done dynamically by inversely setting the base delay adjustment and the counter increment change proportional to the estimated, weighted output values (OPV, OPV').

12. Computer-implemented method according to one of the claims 1 to 11, **characterized in that** the machine-learning module (MLM) is an artificial neural network, a Bayesian neural network, a recurrent neural network, a convolutional neural network, multilayer perceptron, autoencoder, support-vector-machine, a data-driven trainable regression model, a k-nearest neighbor regressor, a physical model, a deep neural network regressor and/or a decision tree regressor.

13. Calibration system (CBSY), in particular used as a computer-implemented-tool (CIT) preferably embodied as a Computer-Program-Product being designed as an "APP" (APP), including

    - a non-transitory, processor-readable storage medium (STM) having processor-readable program-instructions of a program module (PGM) stored in the non-transitory processor-readable storage medium (STM) and
    - a processor (PRC) connected with the storage medium (STM) executing the processor-readable program-instructions of the program module (PGM)

**characterized in that**

    - the program module (PGM) includes (i) a training data generator (TDG), a machine-learning module (MLM) and a preprocessing entity (PRPE) or (ii) a training data generator (TDG), a machine-learning module (MLM), a preprocessing entity (PRPE) and a postprocessing entity (POPE),
    - the processor (PRC) executing the processor-readable program-instructions of the program module (PGM) and thereby accessing to (i) the training data generator (TDG), the machine-learning module (MLM) and the preprocessing entity (PRPE) or (ii) the training data generator (TDG), the machine-learning module (MLM), the preprocessing entity (PRPE) and the postprocessing entity (POPE) such that the computer-implemented method steps of the computer-implemented method according to one of the claims 1 to 12 are executed.

CBSY, (CIT, APP)

Storage Medium    e.g. Random Access Memory

OPV' — STM

POPE

popc

PGM

pvd

OPV

Processor

Machine-learning module — MLM

MLMW

TDG

ipt

trn

Preprocessing — PRPE
entity     prpc

PRC

SCUC

TSY

rcv

IPV, (IPVph, IPV1-ph, IPV3-ph)

IPSn

ACPG — AC power grid — TSY

EP 4 236 079 A1

ANNEX

----PICTURES related to the specification----

Picture 1: a conventional single-phase PLL

Picture 2: a conventional triple-phase PLL

Picture 3: Illustration of the multiple counters with vector of thresholds =[-0.5,   0., 0.5, 0.97 …] and the base incre- ment values "incv_base"

Picture 4: Exemplary simulation-based connection diagram providing inputs and outputs for initialization at "f0_train"= 50Hz, "fs_train"= 8kHz

Picture 5: Exemplary simulation-based connection diagram providing inputs and outputs for initialization at "f0_train"= 60Hz, "fs_train"= 8kHz

Europäisches
Patentamt

European
Patent Office

Office européen
des brevets

## EUROPEAN SEARCH REPORT

**Application Number**

EP 22 15 8856

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 5 705 956 A (NEELY WILLIAM SHIELDS [US]) 6 January 1998 (1998-01-06) * column 1 – column 4; figures 1-6 * | 1-13 | INV. H03L7/10 G06N20/00 |
| A | ALI BECHOUCHE ET AL: "An adaptive neural PLL for grid synchronization", IECON 2012 – 38TH ANNUAL CONFERENCE ON IEEE INDUSTRIAL ELECTRONICS SOCIETY, IEEE, 25 October 2012 (2012-10-25), pages 4451-4456, XP032281756, DOI: 10.1109/IECON.2012.6389469 ISBN: 978-1-4673-2419-9 * paragraph [000I] – paragraph [000V]; figures 1-12 * | 1-13 | |
| A | MCHIRI MOHAMED ET AL: "Neural networks based control of chaotic Phase-Locked Loop", SYSTEMS, SIGNALS AND DEVICES, 2008. IEEE SSD 2008. 5TH INTERNATIONAL MULTI-CONFERENCE ON, IEEE, PISCATAWAY, NJ, USA, 20 July 2008 (2008-07-20), pages 1-5, XP031326834, ISBN: 978-1-4244-2205-0 * paragraph [0001] – paragraph [0006]; figures 1-10 * | 1-13 | TECHNICAL FIELDS SEARCHED (IPC) H03L G06N |
| A | WENJIN DAI ET AL: "A PLL control based on algorithm of BP neural network", COMPUTATIONAL INTELLIGENCE FOR MEASUREMENT SYSTEMS AND APPLICATIONS, 2009. CIMSA '09. IEEE INTERNATIONAL CONFERENCE ON, IEEE, PISCATAWAY, NJ, USA, 11 May 2009 (2009-05-11), pages 97-101, XP031471679, ISBN: 978-1-4244-3819-8 * paragraph [000I] – paragraph [00VI]; figures 1-13 * | 1-13 | |

The present search report has been drawn up for all claims

| Place of search | Date of completion of the search | Examiner |
|---|---|---|
| The Hague | 19 August 2022 | Rafflenbeul, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

**EP 22 15 8856**

**19-08-2022**

| Patent document cited in search report | | Publication date | Patent family member(s) | | Publication date |
|---|---|---|---|---|---|
| US 5705956 | A | 06-01-1998 | DE | 19729650 A1 | 22-01-1998 |
| | | | KR | 980012841 A | 30-04-1998 |
| | | | US | 5705956 A | 06-01-1998 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007147649 A2

- DE 102012209227 A1